# EUROPEAN PATENT APPLICATION

(11) **EP 0 999 586 A2**
(43) Date of publication of application: **10.05.2000**
(21) Application number: 99121767.0
(22) Date of filing: 03.11.1999
(51) Int. Cl.: H01L 23/31, H01L 23/495, H01L 21/56

(54) **Semiconductor device and method of producing same**

(30) Priority: 05.11.1998 JP 31462998
(71) Applicant: SONY CORPORATION, Tokyo (JP)
(72) Inventor: Yotsumoto, Takahiro, Kokubu-shi, Kagoshima-ken (JP); Tanaka, Kenzo, Kokubu-shi, Kagoshima-ken (JP)
(74) Representative: MÜLLER & HOFFMANN Patentanwälte

(57) **Abstract**

A semiconductor device which is reduced in size, reduced in thickness, and excellent in heat dissipation and can simplify the manufacturing steps and a method for producing the semiconductor device. Provision is made of a semiconductor chip, a die pad member for holding the semiconductor chip, a plurality of lead members at a space from the semiconductor chip, metal fine wires for electrically connecting the semiconductor chip and the lead members, and a package body made of a sealing resin R for sealing and fixing the semiconductor chip including the metal fine wires, the die pad member, and the lead members from a front surface side, back surfaces of the die pad member and the lead members being exposed from the package body.

## Description

### BACKGROUND OF THE INVENTION

### 1. Field of the Invention

The present invention relates to a semiconductor device and a method of producing the same.

### 2. Description of the Related Art

In recent years, along with the reduction of size of electronic apparatuses in which semiconductor device are mounted, further reduction of size, reduction of thickness, and increase of density have been demanded from semiconductor devices.

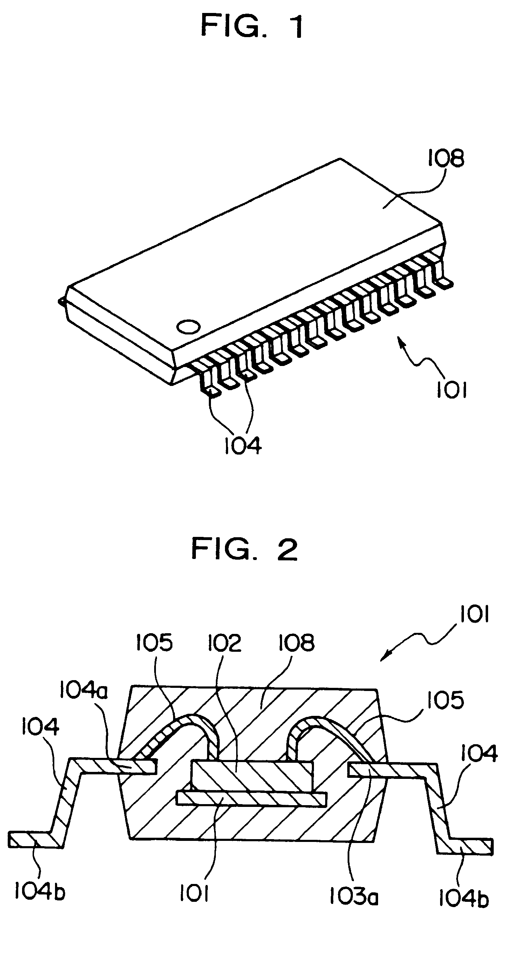

Figure 1 is a perspective view of an example of the configuration of a semiconductor device of the prior art, while Fig.2 is a sectional view of the semiconductor device shown in Fig.1.

In Fig.1. and Fig.2, a semiconductor device 101 has a die pad member 102, a semiconductor chip 103 bonded to and held by the die pad substrate 102, a lead members 104 provided at a space from the semiconductor chip 103, metal fine wires 105 for electrically connecting the semiconductor chip 103 and internal lead portions 104a of the lead members 104, and a package body 108 made of a sealing resin for sealing the semiconductor chip 103 including the metal fine wires 105, the die pad member 102, and the internal lead portions 104a of the lead members 104.

In the semiconductor device 101 having this configuration, first, the semiconductor chip 103 is die-bonded to the die pad member 102 by using for example solder or a conductive binder etc.

Next, a metal fine wire bonding device is used to connect the semiconductor chip 103 and the internal lead portions 104a of the lead members 104 by metal fine wires 105 made of for example gold wire.

Next, a mold and an injection molding press device is used to seal the area around the semiconductor chip 101 by the sealing resin and form the package body 108.

Next, the external lead portions 104b of the lead members 104 projecting out from the sides of the package body 108 are cut to predetermined lengths using a cutting die and the cut lead members 104 are bent as shown in for example Fig.2.

As mentioned above, in the semiconductor device 101 having the above configuration, the external lead portions 104b of the lead members 104 project out from the package body 108, therefore the width of the semiconductor device 101 becomes larger so there exists a disadvantage that the mounting area becomes larger when mounting the semiconductor device 101 on a board.

Processing for bending the external leads 104b of the lead members 104 is necessary, so there also existed a disadvantage that the manufacturing steps of the semiconductor device 101 were increased and, in addition, there also existed a disadvantage that the bent external lead portions 104b easily deform and problems were liable to occur when mounting the semiconductor device 101 on the board or the like.

There was also the disadvantage that, in the step for forming the package body 108, the sealing resin would squeeze out from the package body 108 to between the lead members 104 making a step of removing this squeezed out sealing resin necessary, so the manufacturing steps were further increased.

In the semiconductor device 101 having the above configuration, since the semiconductor chip 101 is encased in the package body 108, there was also a disadvantage that cracking could occur due to the heat from the semiconductor chip 101 and so on.

### SUMMARY OF THE INVENTION

An object according to the present invention is to provide a semiconductor device which is reduced in size, reduced in thickness, and excellent in heat dissipation.

Other object according to the present invention is to provide a method for producing a semiconductor device which does not require formation of external lead portions, does not require a step of removal of the sealing resin squeezed out between the external leads, and thus can simplify the manufacturing steps.

The present invention comprises a semiconductor chip having a semiconductor circuit, a holding member for holding the semiconductor chip on one surface thereof, a plurality of terminal members at a space from the semiconductor chip, connecting members for electrically connecting the semiconductor circuit in the semiconductor chip and the terminal members at one surface thereof, and a package body for fixedly sealing the semiconductor chip, the connecting members, and one surface of the terminal members, with the holding member and the terminal members, another surface of the holding member and another surface of the terminal members being exposed to outside.

Preferably, each terminal member projects out from the side of the package body by a predetermined length, and the sealing resin is interposed between the projecting terminal members.

More Preferably, the terminal members are positioned at an identical plane as that the holding member.

The die pad and the terminal member are formed by same electrical conductive and heat conductive material.

The terminal members are flat.

The another surface of the terminal members comprises connecting surface for electrically connecting to an apparatus.

Further the present invention comprises a step of bonding a semiconductor chip onto a die pad portion of a lead frame integrally connected with the die pad portion for holding the semiconductor chip and a plurality of lead portions provided at a space from the die pad portion, a step of electrically connecting the semiconductor chip and the lead portions by metal fine wires, a step of interposing the lead frame between a first mold having a cavity encompassing the semiconductor chip including the metal fine wires, the die pad portion, and part of the lead portions from the front surface and a second mold having a contact face directly contacting the back surfaces of the die pad portion and lead portions, filling a sealing resin between the first and second molds to form a package body having a predetermined shape, and then interposing the sealing resin between the leads, and a step of cutting regions of the lead frame projecting out from the sides of the package body together with the sealing resin interposed between the lead portions while leaving a predetermined amount from the sides of the package body.

Preferably, the step of cutting the lead frame separates the lead portions and the die pad portion from the lead frame.

In the present invention, the back surfaces of the terminal members are exposed from the package body, so electrical connection with a board or other external apparatus becomes possible by the back surfaces of the terminal members.

Accordingly, the amount of projection of the terminal members from the sides of the package body may be the smallest limit. As a result, the width of the semiconductor device can be reduced.

Since the device is configured with the back surfaces of the terminal members and the holding member exposed from the package body, the sealing resin for sealing from the back surface of the semiconductor device becomes unnecessary, so the thickness of the semiconductor device can be made smaller.

In the present invention, since the back surface of the holding member for holding the semiconductor device is exposed from the package body, heat generated in the semiconductor device can be discharged to the outside with a high efficiency.

The sealing resin is interposed between the terminal members projecting out from the sides of the package body, and the front ends of the terminal members are fixed by the sealing resin. For this reason, the terminal members becomes hard to deform, so the reliability of the semiconductor device rises.

In the method for producing a semiconductor device of the present invention, since the lead portions are cut together with the sealing resin interposed between the lead portions, the step for removing the sealing resin squeezed out between the lead portions becomes unnecessary. In addition, the lead portions are fixed by the sealing resin protruding out between the lead portions, so the deformation of the projected lead portions can be positively prevented.

Further, in the method for producing a semiconductor device of the present invention, since the sealing resin is filled while bringing the contact face of the second mold into direct contact with the lead portions and the die pad portion, the lead portions and the die pad portion are exposed from the package body of the semiconductor device, electrical connection with a board or other external apparatus becomes possible by the back surfaces of the lead portions, and the bending of the lead portions becomes unnecessary, so the manufacturing steps are simplified.

### BRIEF DESCRIPTION OF THE DRAWINGS

These and other objects and features of the present invention will become clearer from the following description of the preferred embodiments given with reference to the accompanying drawings, in which:
Fig.1 is a perspective view of an example of the configuration of a semiconductor device of the prior art;
Fig.2 is a sectional view of the semiconductor device shown in Fig.1;
Fig.3 is a view of the configuration of an embodiment of a semiconductor device of the present invention shown from above by a perspective view;
Fig.4 is a sectional view of the configuration of an embodiment of a semiconductor device of the present invention;
Fig.5 is a perspective view of the configuration of an embodiment of a semiconductor device of the present invention showing the semiconductor device from below by a perspective view;
Fig.6 is a view of an example of the lead frame applied to the semiconductor device according to the present invention;
Fig.7 is a view for explaining a die-bonding process of the method for producing a semiconductor device according to the present invention;
Fig.8 is a sectional view of the semiconductor shown in Fig.7;
Fig.9 is a view for explaining a wire banding process of the method for producing a semiconductor device according to the present invention;
Fig.10 is a sectional view of the semiconductor shown in Fig.9;
Fig.11 is a view for explaining a resin sealing process of the method for producing a semiconductor device according to the present invention;
Fig.12 is a perspective view of the semiconductor shown in Fig.11; and
Fig.13 is a perspective view of the completed semiconductor.

### DESCRIPTION OF THE PREFERRED EMBODIMENTS

Below, an explanation will be made of an embodiment of the present invention by referring to the drawings.

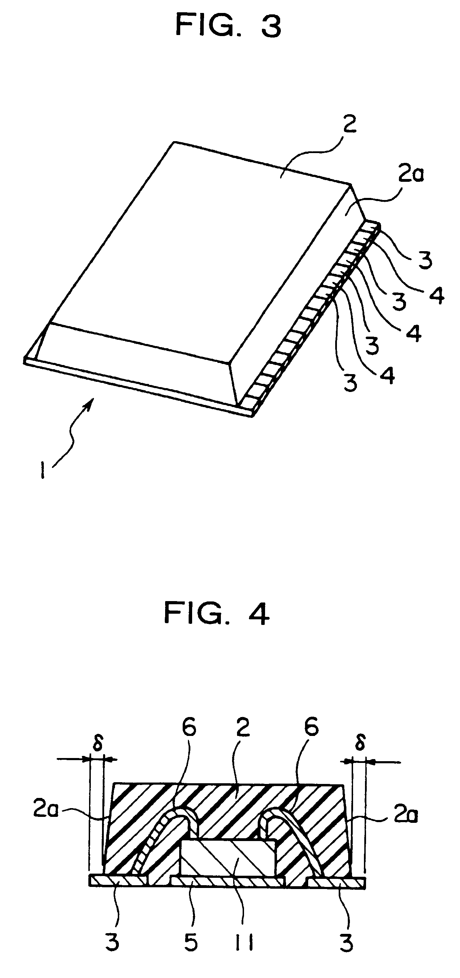

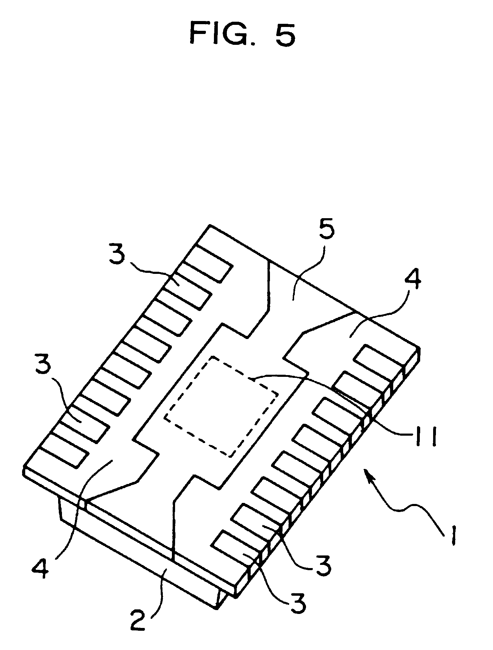

Figure 3 to Fig. 5 are views of the configuration of an embodiment of a semiconductor device of the present invention, wherein Fig.3 is a perspective view of the semiconductor device from above, Fig. 4 is a sectional view, and Fig. 5 is a perspective view of the semiconductor device from below.

As shown in Fig. 3 to Fig.5, the semiconductor device 1 has a semiconductor chip 11, a die pad member 5 for holding the semiconductor chip 11, a plurality of lead members 3 at a space from the semiconductor chip 11 and arranged on an identical plane to that for the die pad member 5, metal fine wires 6 for electrically connecting the semiconductor chip 11 and the lead members 3, and a package body 2 made of a sealing resin for sealing the area around the semiconductor chip 11.

The semiconductor chip 11 for example comprises a silicon substrate on which electronic circuits are integrated and is die-bonded onto the die pad member 5 by using for example solder, a heat curing resin, or a conductive binder etc.

The die pad member 5 is formed by for example a metal material the same as that for the lead member 3 and, as shown in Fig. 3, is provided between two arrays of the lead members 3 and has a broader area than the semiconductor chip 11.

The back surface of the die pad member 5 is exposed to the outside from the semiconductor device 1.

The lead members 3 are comprised by a sheet-like conductive metal material for example, aluminum alloy. A plurality of lead members are provided on the identical plane as that for the die pad member 5. As shown in Fig. 3, a plurality of lead members are arranged at predetermined intervals on the two sides of the semiconductor device 1, and the back surfaces of the lead members 3 are exposed to the outside from the semiconductor device 1.

The front ends of the lead members 3 project out from the sides 2a of the package body 2 as shown in Fig. 3.

The projection length δ of the lead members 3 from the sides 2a of the package body 2 is for example about 0.1 to 0.2 mm.

The sealing resin 4 is interposed between the lead members 3 and the sealing resin 4 is interposed between the lead members 3 and the die pad member 5.

The metal fine wires 6 electrically connect the electrode portions (bonding pad) formed on the semiconductor chip 11 and the corresponding lead members 3 and are comprised by for example a conductive material such as gold wire.

The package body 2 is comprised of the sealing resin and seals and fixes the semiconductor chip 11 including the metal fine wires 6, die pad member 5, and the lead members 3 from the front surface.

As the sealing material comprising the package body 2, a mold resin containing as principal ingredients for example an epoxy resin, curing agent, and filler etc. is used.

According to the semiconductor device 1 having the above configuration, the back surfaces of the lead members 3 are exposed from the package body 2, and electrical connection with a board or other external apparatus becomes possible by the back surfaces of the lead members 3.

Namely, in the semiconductor device 1 having the above configuration, the lead members 3 perform the functions of the external lead members functioning to connect with an external apparatus and the internal lead members functioning to electrically connect with the semiconductor chip in the semiconductor devices of the prior art.

The projection length δ of the lead members 3 from the sides of the package body 2 may be made the smallest limit and, as a result, the width of the semiconductor device 1 can be reduced.

Since the device is configured with the back surfaces of the lead members 3 and the die pad member 3 exposed from the package body 2, the package body 2 is mainly provided on only the front surface side of the semiconductor device 1, so the semiconductor device 1 can be reduced in thickness.

Since the back surface of the die pad member 5 for holding the semiconductor chip 11 is exposed from the package body 2, the heat generated in the semiconductor chip 11 can be efficiently discharged to the outside.

The die pad member 5 is comprised by a metal material, has a high beat conductivity, and in addition has a broader area than the semiconductor chip 11. For this reason, for example the heat generated in the semiconductor chip 11 can be more efficiently discharged to the outside than a case where a semiconductor chip 11 formed on for example a silicon substrate is exposed from the back surface of the semiconductor device 1.

In the semiconductor device 1 having the above configuration, since the sealing resin 4 is interposed between the lead members 2 projecting out from the sides of the package body 2, the lead members 2 are fixed by the sealing resin 4.

For this reason, the lead members 2 are hard to deform and can hold a stable state, so the reliability of the semiconductor device 1 when mounting the semiconductor device 1 on a board or other external apparatus rises.

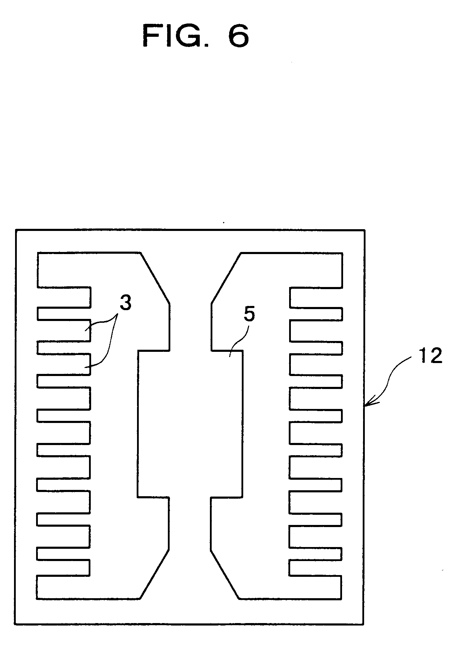

Next, an explanation will be made of a method for producing the semiconductor device 1 having the above configuration by referring to Fig. 6 to 13.

First, as shown in Fig. 6, a lead frame 12 integrally formed with the die pad member 5 and the lead members 3 is prepared.

The lead frame 12 is configured by a sheet material comprised of a copper-based alloy or other conductive metal material. The die pad member 5 and the lead members 3 are formed by a pressing. The die pad member 5 and the lead members3 are connected to the lead frame 12 until separated at a later step.

Note that the die pad member 5 and the lead members 3 can be formed also by for example a chemical etching process in place of the pressing.

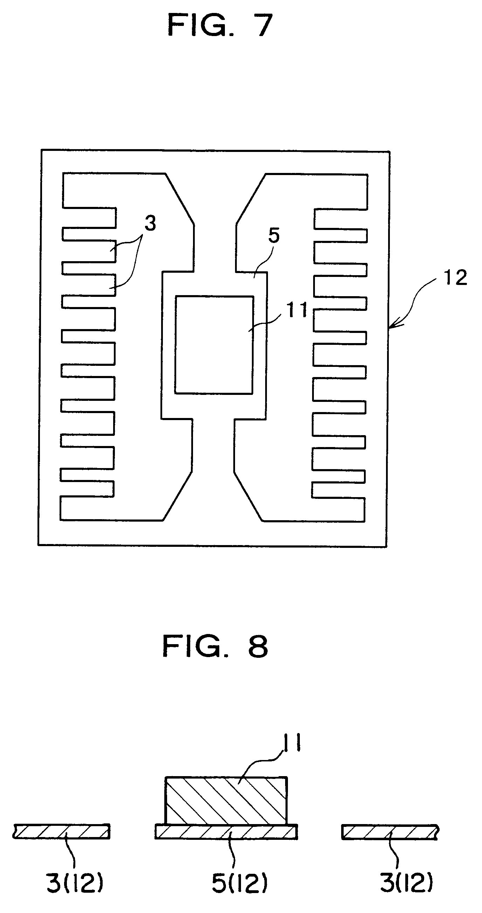

Next, as shown in Fig. 7 and Fig. 8, A semiconductor chip 11 individually separated by dicing is die-bonded on the die pad member 5 of this lead frame 12.

The die-bonding of the semiconductor chip 11 onto the die pad member 5 is performed by for example a paste bonding, an eutectic bonding, a solder bonding manner etc. From a viewpoint of the heat conductivity from the semiconductor chip 11 to the die pad member 5, the use of the eutectic bonding or the solder bonding is preferable.

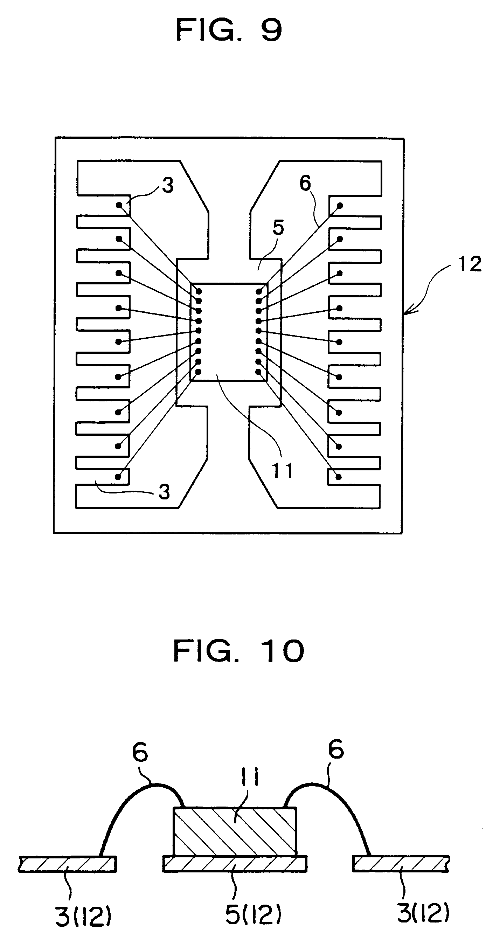

Next, as shown in Fig. 9 and Fig. 10, the bonding pads of the semiconductor chip11 and the corresponding lead members 3 are wire-bonded by the metal fine wires 6.

The wire bonding is carried out by for example using gold wire for the metal fine wires 6, forming a ball at the front end of the gold wire, heat-bonding this ball to a bonding pad of the semiconductor chip 11, leading the gold wire up to the corresponding lead member 3 and heat bonding it, then cutting the gold wire.

Next, the molding step is performed for forming the package body 2 over the lead frame 12 where the semiconductor chip 11 has been die-bonded to the die pad member 5 and the bonding pads of the semiconductor chip 11 and the corresponding lead members 3 have been wire-bonded.

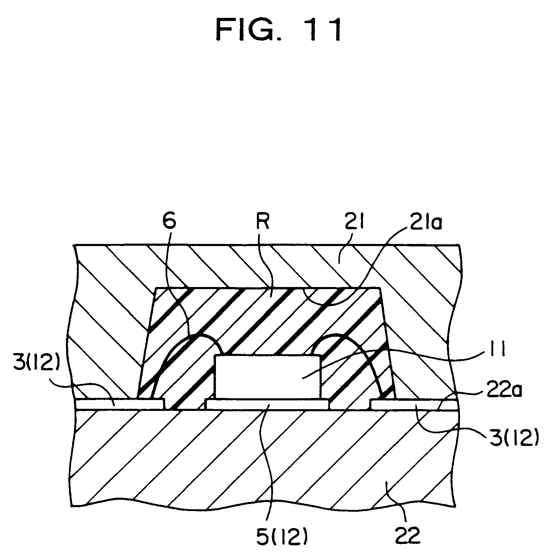

As shown in Fig. 11, a mold is prepared comprising an upper mold 21 formed with a cavity 21a for molding the package body 2 and a lower mold 22 formed with a contact face 22a for contact with the back surfaces of the die pad member 5 and the lead members 3.

The lead frame 12 is sandwiched between the upper mold 21 and the lower mold 22, then a sealing resin R is filled in the cavity 21a and is solidified.

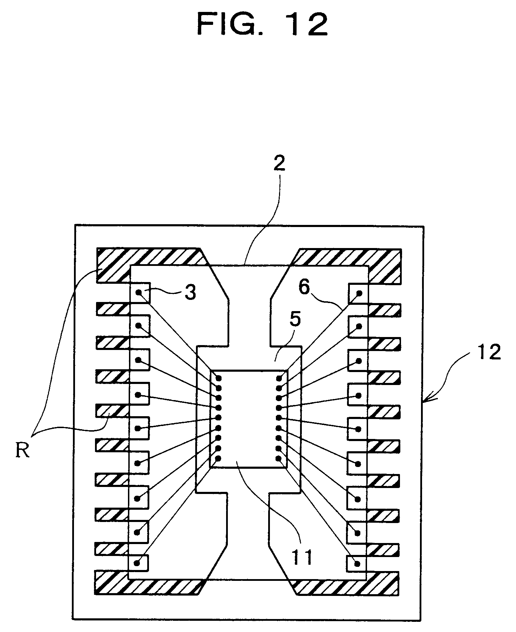

As shown in Fig. 11, the sealing resin R is filled over the semiconductor chip 11, lead members 3, and the die pad member 5. Further, the sealing resin R is filled between the lead members 3 and the die pad member 5.When the sealing resin R is for example polymerized and cured, as shown in Fig. 12, the package body portion 2 is formed.

A state where the sealing resin R protrudes from a space formed by the cavity 21a and the contact face 22a so that the sealing resin R is interposed between the lead members 3 and between the lead members 3 and the die pad member 5 is exhibited.

In this state, the lead frame 12 containing the lead members 3 between which the sealing resin R is interposed projects by a large extent from the sides 2a of the package body portion 2.

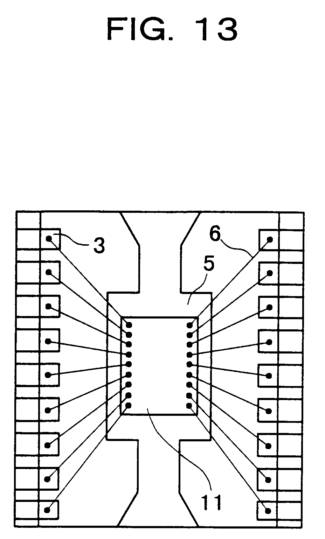

Next, as shown in Fig. 13, the regions of the lead frame 12 projecting from the sides of the package body portion 2 are cut by using for example a cutting die so that the projection length δ of the lead members 3 from the sides of the package body portion 2 becomes a predetermined value.

When cutting the lead frame 12, the sealing resin R interposed between the lead members 3 and between the lead members 3 and the die pad member 5 is simultaneously cut.

By the cutting of the lead frame 12, the lead members 3 and the die pad member 5 are separated from the lead frame 12, whereby the semiconductor device 1 is completed.

As described above, according to the method for producing a semiconductor device according to the present embodiment, since the regions projecting from the sides of the package body 2 are cut so that the projection length δ becomes a predetermined value, sealing resin R interposed between the lead members 3 remains as it is and the step for removing the sealing resin R interposed between the lead members 3 is eliminated.

According to the present invention, the reduction of size and reduction of thickness of a semiconductor device become possible and a semiconductor device which is excellent in heat dissipation and in which the lead portions are hard to deform and the reliability is high can be obtained.

Further, according to the present invention, it is not necessary to bend the external lead members and the step for removing the sealing resin squeezed out between the external leads is not necessary, thus it becomes possible to simplify the manufacturing steps.

While the invention has been described with reference to specific embodiment chosen for purpose of illustration, it should be apparent that numerous modifications could be made thereto by those skilled in the art without departing from the basic concept and scope of the invention.

## Claims

1. A semiconductor device comprising:
a semiconductor chip having a semiconductor circuit;
a holding member for holding said semiconductor chip on one surface thereof;
a plurality of terminal members at a space from said semiconductor chip;
connecting members for electrically connecting said semiconductor circuit in said semiconductor chip and said terminal members at one surface thereof; and
a package body for fixedly sealing said semiconductor chip, said connecting members, and one surface of the terminal members, with the holding member and the terminal members,
another surface of said holding member and another surface of said terminal members being exposed to outside.

2. A semiconductor device as set forth in claim 1, wherein each terminal member projects out from the side of said package body by a predetermined length, and said sealing resin is interposed between the projecting terminal members.

3. A semiconductor device as set forth in claim 1, wherein said terminal members are positioned at an identical plane as that said holding member.

4. A semiconductor device as set forth in claim 1, wherein said die pad and said terminal member are formed by same electrical conductive and heat conductive material.

5. A semiconductor device as set forth in claim 1, wherein said holding member comprises a die pad.

6. A semiconductor device as set forth in claim 1, wherein said terminal members are flat.

7. A semiconductor device as set forth in claim 1, wherein the sealing resin is interposed between the terminal members and the holding member.

8. A semiconductor device as set forth in claim 1, wherein the another surface of the terminal members comprises connecting surface for electrically connecting to an apparatus.

9. A method for producing a semiconductor device, comprising:
a step of bonding a semiconductor chip onto a die pad portion of a lead frame integrally connected with the die pad portion for holding the semiconductor chip and a plurality of lead portions provided at a space from said die pad portion;
a step of electrically connecting said semiconductor chip and said lead portions by metal fine wires;
a step of interposing said lead frame between a first mold having a cavity encompassing the semiconductor chip including said metal fine wires, said die pad portion, and part of said lead portions from the front surface and a second mold having a contact face directly contacting the back surfaces of said die pad portion and lead portions, filling a sealing resin between said first and second molds to form a package body having a predetermined shape, and then interposing the sealing resin between said leads; and
a step of cutting regions of said lead frame projecting out from the sides of said package body together with the sealing resin interposed between said lead portions while leaving a predetermined amount from the sides of the package body.

10. A method for producing a semiconductor device as set forth in claim 9, wherein, said step of cutting said lead frame separates said lead portions and said die pad portion from the lead frame.
